(19) Europäisches Patentamt
European Patent Office
Office européen des brevets

(11) **EP 2 893 791 B1**

(12) **EUROPÄISCHE PATENTSCHRIFT**

(45) Veröffentlichungstag und Bekanntmachung des Hinweises auf die Patenterteilung:
**12.09.2018 Patentblatt 2018/37**

(21) Anmeldenummer: **13762826.9**

(22) Anmeldetag: **16.09.2013**

(51) Int Cl.:
*H05K 13/08* (2006.01)    *G06Q 10/00* (2012.01)

(86) Internationale Anmeldenummer:
**PCT/EP2013/069101**

(87) Internationale Veröffentlichungsnummer:
**WO 2014/075831 (22.05.2014 Gazette 2014/21)**

(54) **BILDUNG VON FESTRÜSTUNGS-RÜSTFAMILIEN ZUR BESTÜCKUNG VON LEITERPLATTEN**

FORMATION OF FIXED EQUIPMENT SETUP FAMILIES FOR POPULATING CIRCUIT BOARDS

FORMATION DE FAMILLES D'ENSEMBLES DE COMPOSANTS FIXES À MONTER SUR DES CIRCUITS IMPRIMÉS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **15.11.2012 DE 102012220904**

(43) Veröffentlichungstag der Anmeldung:
**15.07.2015 Patentblatt 2015/29**

(73) Patentinhaber: **Siemens Aktiengesellschaft 80333 München (DE)**

(72) Erfinder:
• **PFAFFINGER, Alexander 81739 München (DE)**
• **ROYER, Christian 85521 Ottobrunn (DE)**

(56) Entgegenhaltungen:
**WO-A1-2010/105876    DE-A1- 19 834 620**

• **EPO: "Mitteilung des Europäischen Patentamts vom 1. Oktober 2007 über Geschäftsmethoden = Notice from the European Patent Office dated 1 October 2007 concerning business methods = Communiqué de l'Office européen des brevets,en date du 1er octobre 2007, concernant les méthodes dans le domaine des activités", JOURNAL OFFICIEL DE L'OFFICE EUROPEEN DES BREVETS.OFFICIAL JOURNAL OF THE EUROPEAN PATENT OFFICE.AMTSBLATTT DES EUROPAEISCHEN PATENTAMTS, OEB, MUNCHEN, DE, Bd. 30, Nr. 11, 1. November 2007 (2007-11-01), Seiten 592-593, XP007905525, ISSN: 0170-9291**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die vorliegende Erfindung betrifft die Bestückung von Leiterplatten mittels einer Bestückungslinie. Insbesondere betrifft die Erfindung die Bildung einer oder mehrerer Festrüstungs-Rüstfamilien.

Eine Bestückungslinie ist zur Bestückung einer Leiterplatte mit einer Anzahl Bauelemente eingerichtet. Dabei lässt sich unterscheiden zwischen einer Variantenfertigung und einer Festrüstungsfertigung.

In der Variantenfertigung werden für einen kurzen Planungshorizont (ca. 1-5 Tage) die zu fertigenden Leiterplatten in Rüstfamilien ("Cluster") aufgeteilt. Eine Rüstfamilie ist dabei eine Menge von Leiterplatten, die mit einer vorbestimmten Anzahl von Bauelementen auf der Bestückungslinie produzierbar ist. Die Menge der hierfür benötigten Bauteiltypen wird Rüstung genannt und ist üblicherweise in einem Satz von Wechseltischen aufgenommen. Ein Wechseltisch wird üblicherweise in der Vorrüstung zur Produktion mit den passenden Bauteilen aufgerüstet und nachher wieder abgerüstet.

In der Festrüstungsfertigung werden die Rüstungen für die zu fertigenden Baugruppen auf Wechseltischen längerfristig (ca. 6-12 Monate) fest gerüstet. Bei mehreren Festrüstungen pro Bestückungslinie werden beim Rüstfamilienwechsel die Wechseltische entsprechend getauscht. Das Auf- und Abrüsten von Wechseltischen ist dann in der täglichen Produktion nicht mehr erforderlich.

Häufig werden die Fertigungen auch gemischt betrieben, wobei ein Teil der Leiterplatten in Festrüstungsfertigung und ein anderer in Variantenfertigung auf der gleichen Bestückungslinie produziert werden. Wegen des geringeren Aufwands für Planung, Lagerhaltung, Vorrüstung und Umrüstung wird allgemein angestrebt, den Anteil der Festrüstungsfertigung zu erhöhen und den Anteil der Variantenrüstungsfertigung zu reduzieren.

DE 198 34 620 A1 betrifft ein Bestückungsverfahren, bei dem versucht wird, eine Einrichtungszeit für eine Produktionslinie zur Bestückung von Leiterplatten zu verbessern.

WO 2010 105 876 A1 zeigt ein Verfahren zur Bestimmung von Rüstungen für konstante Tische an einer Bestückungslinie.

Die Aufgabe der Erfindung besteht darin, Leiterplatten verbessert zu bestücken. Die Erfindung löst diese Aufgabe mittels eines Verfahrens, eines Computerprogrammprodukts und einer Steuereinrichtung mit den Merkmalen der unabhängigen Ansprüche. Unteransprüche geben bevorzugte Ausführungsformen wieder.

Eine Bestückungslinie zur Bestückung von Leiterplatten mit Bauelementen umfasst eine Festrüstung, die eine Anzahl Bauelementetypen umfasst, die während eines Planungshorizonts unverändert zugeordnet bleiben. Ein Verfahren zur Bestimmung der Festrüstung umfasst Schritte des Erfassens einer Anzahl Leiterplattentypen mit zugeordneten Leiterplatten, die auf der Bestückungslinie innerhalb des Planungshorizonts bestückt werden sollen, des Zuordnens von Leiterplattentypen an eine Festrüstungs-Rüstfamilie, wobei alle Bauelemente zur Bestückung einer Leiterplatte eines Leiterplattentyps der Festrüstungs-Rüstfamilie von der Festrüstung umfasst sind, und des Optimierens der Zuordnung, bis eine Zuordnungsgüte ein vorbestimmtes Maß übersteigt.

Eine Variantenrüstung für eine Teilmenge der Leiterplattentypen, die in keiner Festrüstungs-Rüstfamilie enthalten sind, umfasst alle Bauteiltypen, die zur Bestückung dieser Leiterplattentypen nötig sind. Eine Variantenrüstung wird temporär auf Wechseltischen aufgerüstet und nach der Produktion der Leiterplattentypen wieder abgerüstet. Leiterplattentypen, die im Verlauf eines Betriebs der Bestückungslinie häufig produziert werden sollen, können verbessert der Festrüstung zugeordnet werden, sodass eine Produktivität der Bestückungslinie gesteigert werden kann. Insbesondere kann dafür gesorgt werden, dass an der Bestückungslinie stets eine Rüstung für wenigstens eine Festrüstungs-Rüstfamilie angebracht ist. Die Anzahl der Leiterplattentypen in der Variantenfertigung kann reduziert und ein Rüstaufwand im Vorrüstbereich kann verringert werden. Außerdem können Umrüstzeiten verkürzt oder Umrüsthäufigkeiten verringert sein. Darüber hinaus kann ein Planungsaufwand für Umrüstungen verringert sein.

In einer bevorzugten Ausführungsform wird die Zuordnungsgüte auf der Basis der Anzahl derjenigen Aufträge während des Planungsintervalls bestimmt, deren Leiterplattentypen der Festrüstungs-Rüstfamilie zugeordnet sind, wobei jeder Auftrag die Bestückung einer Anzahl Leiterplatten eines vorbestimmten Leiterplattentyps auf der Bestückungslinie betrifft. Dadurch kann sichergestellt werden, dass eine möglichst große Vielzahl von Aufträgen mittels Rüstung der Festrüstungs-Rüstfamilie bearbeitet werden kann.

In einer weiteren bevorzugten Ausführungsform wird die Zuordnungsgüte auf der Basis der Summe der innerhalb des Planungshorizonts zu bestückenden Leiterplatten derjenigen Leiterplattentypen bestimmt, die der Festrüstungs-Rüstfamilie zugeordnet sind. So kann sichergestellt werden, dass eine möglichst große Anzahl Leiterplatten innerhalb des Planungshorizonts bestückt werden kann, ohne eine Umrüstung zu erfordern.

In noch einer bevorzugten Ausführungsform wird die Zuordnungsgüte auf der Basis der Summe der Produktionszeiten der Leiterplatten, deren Leiterplattentypen der Festrüstungs-Rüstfamilie zugeordnet sind, bestimmt. Dadurch kann ermöglicht sein, dass die Bestückungslinie eine möglichst lange Zeit innerhalb des Planungshorizonts ohne Umrüstung betrieben werden kann.

In noch einer weiteren bevorzugten Ausführungsform wird die Zuordnungsgüte auf der Basis der Summe der Bestückpositionen der Leiterplatten der Leiterplattentypen, die der Festrüstungs-Rüstfamilie zugeordnet sind, bestimmt.

Dadurch kann eine verbesserte Schätzung der Produktionszeit einer Leiterplatte realisiert sein, so dass die Festrüstung länger unterbrechungsfrei an der Bestückungslinie gerüstet sein kann.

Die Zuordnungsgüte kann insbesondere auf der Basis nur ungefähr bekannter Informationen bestimmt werden. In einer Ausführungsform werden während des Planungshorizonts, der beispielsweise sechs Monate oder mehr beträgt, regelmäßig konkrete Aufträge zur Bestückung von Leiterplatten eines Leiterplattentyps erfasst, beispielsweise wöchentlich. Trotzdem können beispielsweise aus historischen Daten, einer Ankündigung eines Auftraggebers oder saisonalen Betrachtungen eines Absatzmarktes für Leiterplatten Kennzahlen vorliegen, die den gesamten Planungshorizont betreffen, insbesondere eine Anzahl erwarteter Aufträge oder eine Anzahl erwarteter zu bestückender Leiterplatten eines vorbestimmten Leiterplattentyps. Die beschriebene Zuordnung der Leiterplattentypen zu einer Festrüstungs-Rüstfamilie kann auf der Basis dieser nur ungenau bekannten Kennzahlen erfolgen, wie oben beschrieben ist.

In einer Ausführungsform ist eine Vielzahl Festrüstungs-Rüstfamilien vorgegeben, denen mittels des beschriebenen Verfahrens Leiterplattentypen zugeordnet werden. Dabei kann eine globale Optimierung aller vorgegebenen Festrüstungs-Rüstfamilien gleichzeitig erfolgen.

In einer besonders bevorzugten Ausführungsform erfolgt das Optimieren mittels Gemischt Ganzzahliger Programmierung. Die Gemischt Ganzzahlige Programmierung stellt einen globalen Optimierungsansatz dar, der leicht erweiterbar ist und für die kommerzielle Lösungsverfahren bzw. Lösungsvorrichtungen erhältlich sind. Mittels Gemischt Ganzzahliger Programmierung können in einer Vielzahl möglicher Lösungen globale Maxima gefunden werden, so dass eine besonders gute Optimierung gefunden werden kann. Erhältliche Verfahren bzw. Vorrichtungen zur Gemischt Ganzzahligen Programmierung werden laufend verbessert, sodass zu erwarten ist, dass zukünftig noch bessere Optimierungsergebnisse erzielbar sein werden.

Das vorbestimmte Maß kann einen Anteil an einem Unterschied zwischen der Zuordnungsgüte und einer maximal erreichbaren Zuordnungsgüte umfassen. Dieser Unterschied wird auch "Gap" genannt. Es ist bevorzugt, ein Optimierungsverfahren zu verwenden, bei dem dieser "Gap" bestimmt werden kann, insbesondere die Gemischt Ganzzahlige Programmierung.

In einer weiteren Ausführungsform wird das Optimieren auch dann abgebrochen, wenn während einer vorbestimmten Bearbeitungszeit keine Zuordnung gefunden werden konnte, deren Zuordnungsgüte das vorbestimmte Maß übersteigt. Dadurch kann verhindert werden, dass ein zu groß gewähltes vorbestimmtes Maß für die Zuordnungsgüte die Bestimmung einer Zuordnung in angemessener Zeit verhindert.

In einer weiteren Ausführungsform werden die Bauelemente der Leiterplattentypen jeder Rüstfamilie einer Anzahl Wechseltische zur Bereitstellung von Bauelementen an der Bestückungslinie zugeordnet und die Zuordnung der Leiterplatten an die Rüstfamilien erfolgt unter der Randbedingung, dass wenigstens eines der Bauelemente nur einer vorbestimmten Menge von Wechseltischen zugeordnet werden kann.

Auf diese Weise kann beispielsweise berücksichtigt werden, dass große Bauteile oder Bauteile mit selten verwendeten Bauformen unter Umständen nur an vorbestimmten Wechseltischen bereitgehalten werden können.

Die Zuordnung der Leiterplattentypen auf die Rüstfamilien kann auch unter der Randbedingung erfolgen, dass ein maximaler Füllgrad der Wechseltische nicht überschritten wird. Dadurch kann Spielraum gelassen werden für Änderungen oder für mechanische Gegebenheiten, beispielsweise wenn nicht in jedem Fall Bauteile zweier beliebiger Bauteiltypen in unmittelbarer Nachbarschaft am Wechseltisch angebracht werden können.

In noch einer Ausführungsform kann die Zuordnung unter der Randbedingung erfolgen, dass die Leiterplattentypen einer vorbestimmten Menge der gleichen Rüstfamilie zugeordnet werden. So können beispielsweise Leiterplatten, die an ihrer Ober- und Unterseite bestückt werden sollen, verbessert organisiert werden.

Alternativ dazu kann auch eine Randbedingung angegeben sein, nach der die Leiterplattentypen einer vorbestimmten Menge unterschiedlichen Rüstfamilien zugeordnet werden. Dadurch kann beispielsweise eine Verarbeitung der bestückten Bauelemente mit unterschiedlichen Loten unterstützt sein, mittels dessen die Bauelemente versehen werden.

Ferner sind ein Computerprogrammprodukt zur Durchführung des beschriebenen Verfahrens auf einer Verarbeitungseinrichtung und eine Vorrichtung zur Durchführung der Zuordnung angegeben.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden, wobei

Fig. 1    ein Bestückungssystem;

Fig. 2    eine Veranschaulichung von Rüstfamilien an einer Bestückungslinie von Fig. 1;

Fig. 3    ein Ablaufdiagramm eines Verfahrens zum Zuordnen von Leiterplatten zu Rüstfamilien

darstellt.

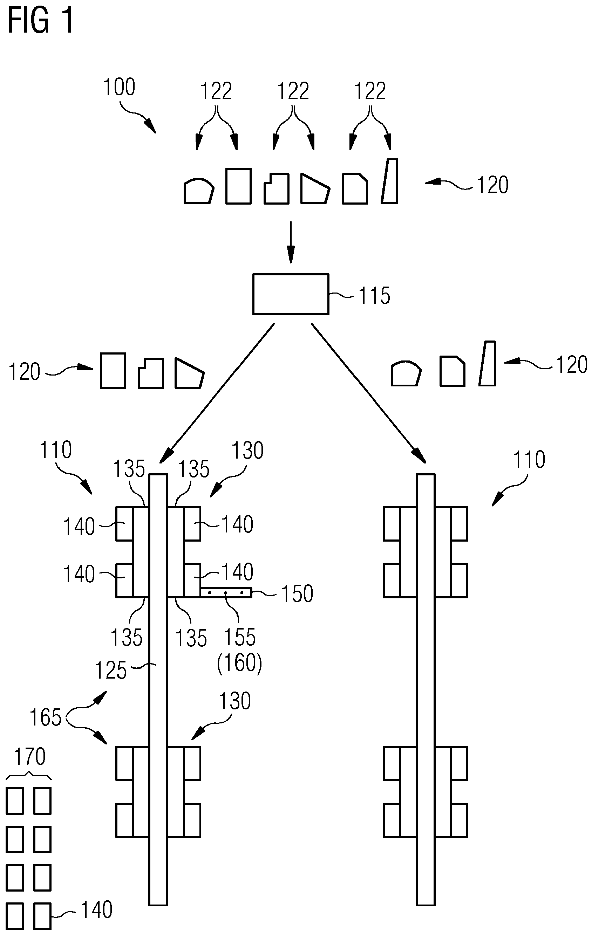

Figur 1 zeigt ein Bestückungssystem 100. Das Bestückungssystem 100 umfasst eine oder mehrere Bestückungslinien 110 und eine Steuereinrichtung 115. Jede Bestückungslinie 110 umfasst ein optionales Transportsystem 125 sowie einen oder mehrere Bestückungsautomaten 130. Jeder Bestückungsautomat 130 umfasst einen oder mehrere Bestückungsköpfe 135, die jeweils dazu eingerichtet sind, von einem Wechseltisch 140 Bauelemente 155 aufzunehmen und an einer vorbestimmten Position auf der Leiterplatte 120 zu positionieren, die sich auf dem Transportsystem 125 befindet.

Während des Bestückungsvorgangs steht die Leiterplatte 120 bezüglich des Bestückungsautomaten 130 üblicherweise still. Die Wechseltische 140 umfassen jeweils eine Vielzahl Zuführungseinrichtungen 150, von denen in Figur 1 exemplarisch nur eine dargestellt ist. Jede Zuführungseinrichtung 150 hält einen Vorrat von Bauelementen 155 eines vorbestimmten Bauelementetyps 160 bereit. Für die Bauelemente 155 hat die Zuführungseinrichtung 150 ein Fassungsvermögen, das üblicherweise in Spuren ausgedrückt wird. Eine Spur ist üblicherweise 8 mm breit und die Zahl der Spuren jeder Zuführungseinrichtung 150 ist beschränkt, beispielsweise auf 40. Bauelemente 155 des gleichen Bauelementetyps 160 sind üblicherweise bereitgestellt in einem Gurt, auf einem Tablett oder in einer Röhre. Jeder Bauelementetyp 160 erfordert an der Zuführungseinrichtung 150 eine vorbestimmte Anzahl Spuren, die üblicherweise aneinander angrenzen müssen.

Jede Zuführungseinrichtung 150 kann zur Bereithaltung unterschiedlicher Bauelemente 155 konfiguriert werden und üblicherweise können unterschiedliche Zuführungseinrichtungen 150 an einem Wechseltisch 140 angebracht werden. Wird ein Bauelement 155 eines Bauelementtyps 160 am Bestückungsautomaten 130 benötigt, der nicht in einem der Wechseltische 140 vorhanden ist, so wird üblicherweise nicht einer der angebrachten Wechseltische 140 mit den benötigten Bauelementen 155 versehen, sondern komplett gegen einen anderen, entsprechend bestückten Wechseltisch 140 ausgetauscht. Das Aufrüsten eines einzuwechselnden Wechseltischs 140 mit Bauelementen 155 wird Vorrüstung genannt und kann eine Bearbeitungszeit im Stundenbereich erfordern.

Da ein Wechsel von Wechseltischen 140 an der Bestückungslinie 110 üblicherweise mit einem Produktionsstillstand verbunden ist, wird angestrebt, möglichst seltene Wechsel der Wechseltische 140 durchzuführen.

Zur Bestückung einer vorbestimmten Menge von Leiterplatten 120 können Rüstungen gebildet sein, die jeweils Vorräte von Bauelementen 155 von vorbestimmten Bauelementtypen 160 umfassen, wobei jede der Leiterplatten 120 der Menge mit Bauelementen 155 der Rüstung vollständig bestückt werden kann. Eine Rüstung kann realisiert sein durch eine Anzahl Wechseltische 140. In der Darstellung von Figur 1 sind eine Festrüstung 165, deren Wechseltische 140 an der Bestückungslinie 110 angebracht sind, und eine Variantenrüstung 170, deren Wechseltische 140 von der Fertigungslinie 110 getrennt sind, gebildet. Es können eine oder mehrere Festrüstungen 165 und eine oder mehrere Variantenrüstungen 170 vorgesehen sein. Ein angestrebter Fall ohne Variantenrüstungen 170 ist möglich aber in der Praxis kaum erzielbar.

Die Festrüstung 165 ist dazu eingerichtet, zumindest während eines Planungshorizonts, der beispielsweise ein halbes Jahr oder ein Jahr betragen kann, bezüglich seiner Bauelementtypen 160 unverändert zu bleiben. Es können also im Bedarfsfall zwar Bauelemente 155 an den Wechseltischen 140 der Festrüstung 165 nachgefüllt werden, die Zuordnung von Bauelementtypen 160 zu Spuren der Wechseltische 140 bleibt jedoch unverändert. Sind mehrere Festrüstungen 165 vorgesehen, so können diese innerhalb des Planungshorizonts gegeneinander oder gegen eine der Variantenrüstungen 170 ausgetauscht werden.

Eine Variantenrüstung 170 hingegen ist dazu eingerichtet, während des Planungshorizonts Bauelemente 155 unterschiedlicher Bauelementetypen 160 aufzunehmen, besteht aber nur temporär. Dazu werden üblicherweise die Wechseltische 170, während sie nicht an der Bestückungslinie 110 angebracht sind, von Bauelementen 155 vorbestimmter Bauelementtypen 160 abgerüstet und mit Bauelementen 155 anderer Bauelementtypen 160 aufgerüstet. Diese Umrüstung kann einen erheblichen Anteil manueller Arbeit umfassen und zeitaufwändig sein.

Die Steuereinrichtung 115 ordnet Leiterplattentypen 122, deren zugeordnete Leiterplatten 120 auf der Bestückungslinie 110 bestückt werden sollen, einer Rüstfamilie zu. Eine Rüstfamilie ist eine Menge von Leiterplattentypen 122, deren Leiterplatten 120 vollständig mit Bauelementen 155 bestückt werden können, die in der zugeordneten Rüstung 165, 170 bereitgestellt sind. Eine Rüstfamilie ist üblicherweise genau einer Rüstung 165, 170 zugeordnet und umgekehrt.

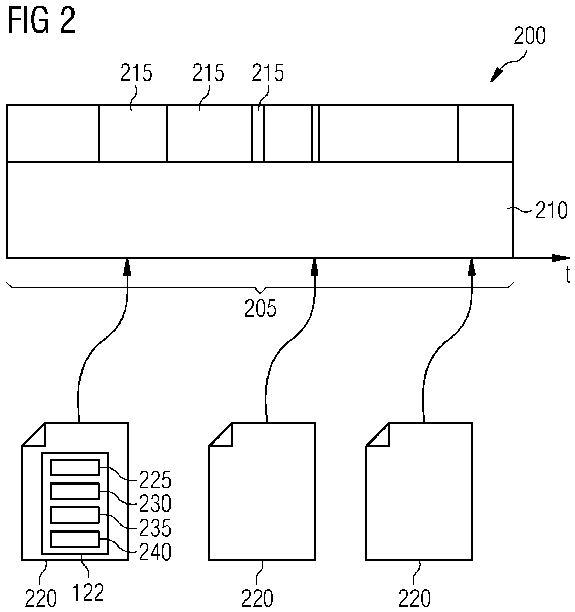

Figur 2 zeigt eine Veranschaulichung von Rüstfamilien an einer Bestückungslinie 110 aus Figur 1. Während eines Planungshorizonts 210 sind an der Bestückungslinie 110 eine Festrüstungs-Rüstfamilie 210 und nacheinander unterschiedliche Variantenfertigungs-Rüstfamilien 215 gerüstet.

Der Planungshorizont 205 umfasst bevorzugter Weise einen längeren Zeitraum, beispielsweise ca. 6 bis 12 Monate. Während des Planungshorizonts 205 treffen regelmäßig oder unregelmäßig Aufträge 220 ein, die eine kurzfristige Bestückung von Leiterplatten 120 mit Bauelementen 155 betreffen. Jeder Auftrag 220 umfasst wenigstens den Leiterplattentyp 122 und eine Stückzahl 225 zu bestückender Leiterplatten 120.

Dem Leiterplattentyp 122 können weitere Informationen zugeordnet sein. Beispielsweise können eine Anzahl 230 von Bauelementetypen 235, die auf jeder Leiterplatte 120 bestückt werden sollen, eine Anzahl 235 von Bestückpositionen einer Leiterplatte 120 oder eine Produktionszeit 240 für eine Leiterplatte 120, jeweils des Leiterplattentyps 122, angegeben sein. Die Anzahl der Bestückpositionen entspricht der Anzahl der auf einer Leiterplatte 120 des Leiterplattentyps 122 zu bestückenden Bauteile 155, gleich welches Bauteiltyps 160.

Häufig wird eine Zuordnung der Leiterplattentypen 122 an die Rüstfamilien 210 und 215 dann durchgeführt, wenn der bzw. die konkreten Aufträge 220 bereits vorliegen. Vorliegend wird vorgeschlagen, eine Kenntnis über zukünftige Aufträge 220, die innerhalb des Planungshorizonts 205 erwartet werden, aber noch nicht notwendigerweise entgegen genommen sind, in die Zuordnung mit einzubeziehen. Dabei handelt es sich beispielsweise um Erfahrungswerte aus zurückliegenden Aufträgen 220 oder um zusätzliche Informationen, die beispielsweise von einem Kunden bereitgestellt sind. Durch die Berücksichtigung dieser Informationen kann die Festrüstungs-Rüstfamilie 210 vergrößert werden, sodass weniger bzw. weniger aufwändige Rüstwechsel während des Planungshorizonts zu erwarten sind.

Insbesondere ist es wünschenswert, solche Leiterplattentypen 122 der Festrüstungs-Rüstfamilie 210 zuzuordnen, deren zugeordneten Aufträge 220 häufig erfolgen, deren während des Planungshorizonts 205 zu bestückende gesamte Stückzahl Leiterplatten 120 groß ist oder die die Bestückungslinie 110 über den Planungshorizont 205 lange auslasten.

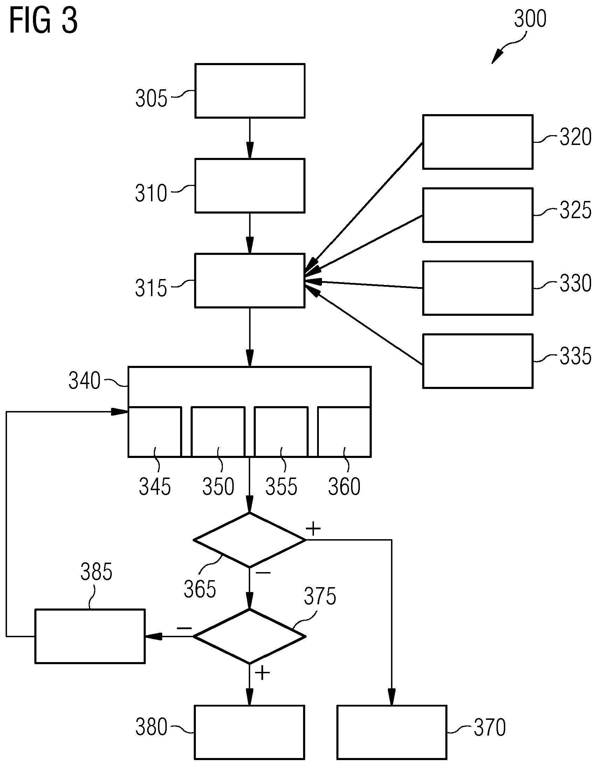

Figur 3 zeigt ein Ablaufdiagramm eines Verfahrens 300 zum Zuordnen von Leiterplatten 120 zu Rüstfamilien 210 oder 215 entsprechend der Ausführungen zu den Figuren 1 und 2.

Schritt 305: optional kann in diesem Schritt die Anzahl der Festrüstungs-Rüstfamilien 210 vorgegeben werden. Diese Anzahl beträgt mindestens Eins und kann auch beispielsweise in Abhängigkeit vorhandener Wechseltische 140 andere Werte annehmen.

Schritt 310: Informationen über abzusehende Aufträge 220 im Planungshorizont 205 werden erfasst. Diese Informationen können insbesondere zusammenfassender Natur sein und beispielsweise eine Anzahl Aufträge 220 innerhalb des Planungshorizonts 220 oder eine Anzahl zu bestückender Leiterplatten 120 eines vorbestimmten Leiterplattentyps 122 innerhalb des Planungshorizonts 220 betreffen. Diese Informationen können insbesondere auf der Basis historischer Daten oder einer anderen Heuristik erfasst werden. Bei der Erfassung dieser Informationen können auch konkrete Aufträge 220, die erst später im Planungshorizont 205 aktuell werden, berücksichtigt werden.

Schritt 315: es wird eine Startlösung einer Zuordnung der Leiterplattentypen 122 zu einer oder mehreren Festrüstungs-Rüstfamilien 210 bestimmt. Bei der Bildung der Startlösung werden diejenigen Leiterplattentypen 122 bestimmt, die der oder den Festrüstungs-Rüstfamilien 210 zugeordnet werden. Eine Zuordnung der restlichen Leiterplattentypen 122 zu einer Variantenfertigungs-Rüstfamilie 215 muss dabei noch nicht erfolgen.

Schritt 320: Beim Zuordnen im Schritt 315 können verschiedene Randbedingungen zusätzlich berücksichtigt werden. Beispielsweise kann im Schritt 320 eine Zuordnung zwischen einem Bauelementetyp 122 und einem vorbestimmten Wechseltisch 140 berücksichtigt werden.

Schritt 325: Alternativ oder zusätzlich kann in diesem Schritt ein maximaler Füllgrad eines der Wechseltische 140 oder ein maximaler Füllgrad aller Wechseltische 140 der Bestückungslinie 110 berücksichtigt werden.

Schritt 330: Ebenfalls alternativ oder zusätzlich kann die Zuordnung unter der Randbedingung erfolgen, dass die Leiterplattentypen 122 einer vorbestimmten Menge der gleichen Rüstfamilie zugeordnet werden. So können beispielsweise Leiterplatten 120, die an ihrer Ober- und Unterseite bestückt werden sollen, verbessert organisiert werden.

Schritt 335: In entsprechender Weise können Leiterplattentypen 122 einer weiteren vorbestimmten Menge unterschiedlichen Rüstfamilien zugeordnet werden. Beispielsweise kann dadurch eine Verarbeitung der Leiterplatten 120 mit unterschiedlichen Loten unterstützt sein, mit denen die Bauelemente 155 einer Leiterplatte 120 versehen werden, um in einem folgenden Verfahren beispielsweise in einem Reflow-Ofen an der Leiterplatte 120 festgelötet zu werden.

Schritt 340: Eine Zuordnungsgüte der im Schritt 315 durchgeführten Zuordnung wird auf der Basis der im Schritt 310 erfassten Informationen und gegebenenfalls der im Schritt 305 erfassten Aufträge 220 bestimmt. Zur Bestimmung der Zuordnungsgüte sind unterschiedliche Vorgehensweisen möglich, die auch miteinander kombinierbar sind. Es können eine oder mehrere Kennzahlen bestimmt werden, die der Zuordnungsgüte zu Grunde gelegt werden. Auf der Basis jeder Kennzahl, die in den folgenden Schritten 345 bis 360 bestimmt werden, kann eine Zuordnungsgüte bestimmt werden und die einzelnen Zuordnungsgüten können mittels einer gewichteten Summe zu einer gesamten Zuordnungsgüte zusammen gefasst werden.

Schritt 345: In einer ersten Vorgehensweise wird eine Anzahl Aufträge 220 im Planungsintervall 205 bestimmt, deren Leiterplattentypen 122 der Festrüstungs-Rüstfamilie 210 zugeordnet sind. Die Zuordnungsgüte wird anschließend auf der Basis der bestimmten Anzahl bestimmt.

Schritt 350: In einer zweiten Vorgehensweise wird eine Anzahl Leiterplatten 120 im Planungsintervall 205 bestimmt, deren zugeordnete Leiterplattentypen 122 der Festrüstungs-Rüstfamilie 210 zugeordnet sind. Die Zuordnungsgüte wird dann auf der Basis der bestimmten Anzahl bestimmt.

Schritt 355: In einer dritten Vorgehensweise wird die Summe der Produktionszeiten derjenigen Leiterplatten 120 im Planungsintervall 205 bestimmt, deren Leiterplattentypen 122 der Festrüstungs-Rüstfamilie 210 zugeordnet sind. Die Zuordnungsgüte wird dann auf der Basis der bestimmten Summe bestimmt.

Schritt 360: In einer vierten Vorgehensweise wird die Summe der Bestückpositionen 235 der Leiterplatten 120 aller Aufträge, deren Leiterplattentypen 122 der Festrüstungs-Rüstfamilie 210 zugeordnet sind, bestimmt. Die Zuordnungsgüte wird dann auf der Basis der bestimmten Summe bestimmt.

Schritt 365: Die bestimmte Zuordnungsgüte wird mit einem vorbestimmten Maß verglichen. Das vorbestimmte Maß kann absolut angegeben sein, beispielsweise in Form einer Zahl, einer Anzahl oder einer Zeit. Das Maß kann auch relativ angegeben sein, beispielsweise in Form eines Verhältnisses mehrerer solcher Angaben. In einer bevorzugten Ausführungsform ist das vorbestimmte Maß auf der Basis einer maximal erreichbaren Zuordnungsgüte angegeben. Beispielsweise kann das vorbestimmte Maß 95% der maximal erreichbaren Zuordnungsgüte betreffen.

Schritt 370: Fällt der Vergleich von Schritt 355 positiv aus, so wird die bestimmte Zuordnung ausgegeben. Leiterplattentypen 122, die an dieser Stelle noch keiner Festrüstungs-Rüstfamilie 210 zugeordnet sind, können dann in einem separaten Verfahren auf eine oder mehrere Variantenfertigungs-Rüstfamilien 215 aufgeteilt werden.

Schritt 375: Fällt der Vergleich im Schritt 355 negativ aus, ist also die bestimmte Zuordnungsgüte kleiner als das vorbestimmt Maß, so kann in diesem optionalen Schritt geprüft werden, ob eine vorbestimmte Bearbeitungszeit zum Durchlaufen des Verfahrens 300 bereits abgelaufen ist.

Schritt 380: Ist dies der Fall, so wird das Verfahren 300 im Schritt 370 abgebrochen.

Schritt 385: Anderenfalls wird die bestimmte Zuordnung bezüglich der Zuordnungsgüte optimiert. Danach fährt das Verfahren 300 mit dem Schritt 340 fort.

Bevorzugterweise erfolgen die Schritte 315 - 385 durch Lösen eines Gemischt Ganzzahligen Programms. Optimierer auf der Basis Gemischt Ganzzahliger Programmierungen sind als kommerzielle Produkte erhältlich.
In einer anderen Ausführungsform wird bei jedem Durchlauf der genannten Schritte die beste bislang bestimmte Zuordnung pseudo-zufällig oder nach einer Heuristik variiert, sodass sich veränderte Zuordnungen ergeben, von denen die beste ausgewählt wird.

Mathematischer Hintergrund

Durch den Einsatz von mathematischen Verfahren lassen sich für die Zuordnung von Leiterplattentypen 122 zu einer Festrüstungs-Rüstfamilie 210 deutlich bessere Lösungen erzielen als mit bisher in der Praxis verwendeten Vorgehensweisen.
Zur Bestimmung einer optimierten Zuordnung von Leiterplattentypen 122 zu einer Festrüstungs-Rüstfamilie 210 kann eine automatische Optimierung verwendet werden. Dabei können beliebige Optimierungsverfahren verwendet werden, beispielsweise auf der Basis von lokalen Suchverfahren oder metaheuristischen Algorithmen.
Bevorzugterweise wird jedoch ein IP-Modell (Integer Programmierung bzw. Integer Programm oder Gemischt Ganzzahliges Optimierungsmodell) verwendet. Eines der Hauptverfahren auf dem Gebiet der mathematischen Optimierung ist die Lineare Optimierung, die sich mit der Optimierung linearer Zielfunktionen über einer Menge befasst, die durch lineare Gleichungen und Ungleichungen eingeschränkt ist. Die Lineare Optimierung ist die Grundlage der Lösungsverfahren der (Gemischt) Ganzzahligen Linearen Optimierung.
Vorteile der Linearen Optimierung:

-    Globaler Optimierungsansatz.
-    Leicht erweiterbar.
-    Sehr gute kommerzielle Standard-Solver (SCIP, CPLEX, Ilog, Xpress), die in der Praxis weit verbreitet und bewährt sind.

- Für eine ermittelte Lösung ist bekannt, wie weit sie maximal von der optimalen Lösung entfernt ist (Gap).

Im Folgenden werden Beispiele für IP-Formulierungen zur Optimierung der beschriebenen Zuordnung von Leiterplattentypen 122 zu einer Festrüstungs-Rüstfamilie 210 gegeben.

**Indices**

C       Menge der Bauelementtypen 155
R       Menge der Leiterplatten 120
$R_c$   Menge der Leiterplatten mit Bauelementtyp c
F       Menge der Festrüstungs-Rüstfamilien 210

**Parameter**

$Width_c$   Platzverbrauch eines Bautelementetyps c in Spuren

$CaP_{cl}$   Anzahl der Spuren der Bauelementtypen, die in der Rüstung der Festrüstungs-Familie cl Platz haben

$Order_r$   Anzahl der Aufträge für die Baugruppe r

**Binär-Variablen**

$Assign_{r,cl}$   hat den Wert 1, falls ein Leiterplattentyp r der Festrüstungs-Familie cl zugeordnet wird, ansonsten den Wert 0

$Setup_{c,cl}$   hat den Wert 1, falls der Bauelementtyp c in der Rüstung der Festrüstungs-Familie cl gerüstet werden muss, ansonsten den Wert 0

**IP Formulierung**

Die Optimierung kann bezüglich der Anzahl der Aufträge zur bestückung von Leiterplattentypen 122 erfolgen:

$$maximize \sum_{r \in R} \sum_{cl \in F} Order_r Assign_{r,cl}$$

s.t.:

$$\sum_{cl \in F} Assign_{r,cl} \leq 1 \qquad r \in R$$

$$\sum_{r \in R} Assign_{r,cl} \leq |R_c| Setup_{c,cl} \qquad c \in C; cl \in F$$

$$\sum_{c \in C} Width_c Setup_{c,cl} \leq Cap_{cl} \qquad cl \in F$$

$$Setup_{c,cl} \in \{0,1\} \qquad\qquad c \in C, cl \in F$$

$$Assign_{r,cl} \in \{0,1\} \qquad\qquad r \in R, cl \in F$$

Es kann auch eine Optimierung bezüglich der Summe der zu bestückenden Leiterplatten bestimmt werden. Die IP-Bedingung lautet dann:

$$maximize \sum_{r \in R} \sum_{cl \in F} AnzahlLeiterplatten_r Assign_{r,cl}$$

wobei AnzahlLeiterplatten$_r$: Anzahl der zu bestückenden Leiterplatten des Typs r im Planungshorizont.
Ferner kann eine Optimierung bezüglich der Produktionszeiten der zu bestückenden Leiterplatten bestimmt werden:

$$maximize \sum_{r \in R} \sum_{cl \in F} ProdTime_r Assign_{r,cl}$$

ProdTime$_r$: Summe der Produktionszeiten der Leiterplatten des Typs r im Planungshorizont.
Weiter kann die Zuordnungsgüte auf der Basis der Produktionszeiten der zu bestückenden Leiterplatten bestimmt werden:

$$maximize \sum_{r \in R} \sum_{cl \in F} BPos_r Assign_{r,cl}$$

BPos$_r$: Summe der Summe der Bestückpositionen der Leiterplatten des Typs r im Planungshorizont.
In einer Variante kann die gesamte Zuordnungsgüte auch auf der Basis einer gewichteten Summe mehrerer der oben genannten Zuordnungsgüten bestimmt werden.
Zur Verbesserung der Zuordnung von Leiterplattentypen 122 zu der Festrüstungs-Rüstfamilie 210 können dem Solver weitere Bedingungen angegeben werden, die oben mit Bezug auf die Schritte 320 bis 335 genauer angegeben sind.
Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

**Patentansprüche**

1. Verfahren (300) zum Bestücken von Leiterplatten (120) mittels einer Rüstung (165, 170) auf einer Bestückungslinie (110),

    - wobei die Rüstung (165, 170) eine Anzahl Bauelementetypen (160) umfasst, die zur Bestückung einer der Rüstung (165, 170) zugeordneten Rüstfamilie (210, 215) von Leiterplattentypen (122) ausreicht,
    - wobei die Rüstung (165, 170) realisierbar ist durch eine Anzahl von Wechseltischen (140), die an der Bestückungslinie (110) angebracht sind und die Vorräte von Bauelementen (155) der Bauelementtypen (160) umfassen,
    - wobei während eines Planungshorizonts (205) unterschiedliche Rüstungen (165, 170) an der Bestückungslinie (110) angebracht werden,
    - wobei eine Festrüstung (165), die auf Wechseltische (140, 145) fest gerüstet wird, während des Planungshorizonts (205) unverändert bleibt und mehrfach an der Bestückungslinie (110) eingesetzt werden kann;
    - und eine Variantenrüstung während des Planungshorizonts nur temporär auf Wechseltischen (140) aufgerüstet und nach der Produktion von Leiterplatten wieder abgerüstet wird, und wobei das Verfahren folgende Schritte umfasst:

- Erfassen (305) einer Anzahl Leiterplattentypen (122) mit zugeordneten Leiterplatten (120), die auf der Bestückungslinie (110) innerhalb des Planungshorizonts (205) bestückt werden sollen;
- Zuordnen (315) von Leiterplattentypen (122) an eine Festrüstungs-Rüstfamilie (210),
- wobei alle Bauelemente (155) zur Bestückung einer Leiterplatte (120) eines Leiterplattentyps (122) der Festrüstungs-Rüstfamilie (210) von der Festrüstung (165) umfasst sind;
- wobei das Zuordnen (315) derart erfolgt, dass ein Platzverbrauch an Spuren der einer Festrüstungs-Rüstfamilie (210) zugeordneten Bauelementtypen (160) kleiner oder gleich der Anzahl Spuren ist, die in der Festrüstung (165) Platz haben;
- wobei den Leiterplattentypen (122) Informationen über die Anzahl der auf ihnen zu bestückenden Bauelementtypen (160) und über eine Anzahl Bestückpositionen (235) jeder Leiterplatte (120) zugeordnet sind;
- Optimieren (375) der Zuordnung mittels Gemischt Ganzzahliger Programmierung, bis eine Zuordnungsgüte ein vorbestimmtes Maß übersteigt;
- wobei die Zuordnungsgüte auf der Basis einer der folgenden Möglichkeiten bestimmt (340) wird:

  a) einer Anzahl von Aufträgen (220) während des Planungsintervalls (205), wobei jeder Auftrag (220) eine Bestückung einer Anzahl Leiterplatten (120) eines vorbestimmten Leiterplattentyps (122) der Festrüstungs-Rüstfamilie (210) betrifft;
  b) der Summe der innerhalb des Planungshorizonts (205) zu bestückenden Leiterplatten (120) derjenigen Leiterplattentypen (122), die der Festrüstungs-Rüstfamilie (210) zugeordnet sind;
  c) der Summe der Produktionszeiten der innerhalb des Planungshorizonts (205) zu bestückenden Leiterplatten (120) derjenigen Leiterplattentypen (122), die der Festrüstungs-Rüstfamilie (210) zugeordnet sind; und
  d) der Summe der Bestückpositionen (235) der Leiterplatten (122) der Leiterplattentypen (122), die der Festrüstungs-Rüstfamilie (210) zugeordnet sind,

  - und
  - Bestücken der Leiterplatten (120) auf der Bestückungslinie (110) mittels der Festrüstung (165).

2. Verfahren (300) nach Anspruch 1, wobei eine Vielzahl Festrüstungs-Rüstfamilien (210) vorgegeben ist.

3. Verfahren (300) nach einem der vorangehenden Ansprüche, wobei das vorbestimmte Maß einen Anteil an einem Unterschied zwischen der Zuordnungsgüte und einer maximal erreichbaren Zuordnungsgüte umfasst (355).

4. Verfahren (300) nach einem der vorangehenden Ansprüche, wobei das Optimieren (375) auch dann abgebrochen (370) wird, wenn während einer vorbestimmten Bearbeitungszeit keine Zuordnung gefunden werden konnte, deren Zuordnungsgüte das vorbestimmte Maß übersteigt.

5. Verfahren (300) nach einem der vorangehenden Ansprüche, wobei die Bauelemente (155) der Leiterplattentypen (160) jeder Rüstfamilie (210) einer Anzahl Wechseltische (140, 145) zur Bereitstellung von Bauelementen (155) an der Bestückungslinie (110) zugeordnet werden und die Zuordnung der Leiterplattentypen (122) an die Rüstfamilien (210) unter der Randbedingung erfolgt (320), dass wenigstens eines der Bauelemente (155) nur einer vorbestimmten Menge von Wechseltischen (140, 145) zugeordnet werden kann.

6. Verfahren (300) nach einem der vorangehenden Ansprüche, wobei die Bauelemente (155) der Leiterplattentypen (122) jeder Rüstfamilie (210) einer Anzahl Wechseltische (140 145) zur Bereitstellung von Bauelementen (155) an der Bestückungslinie (110) zugeordnet werden und die Zuordnung der Leiterplattentypen (122) an die Rüstfamilien (210) unter der Randbedingung erfolgt (325), dass ein maximaler Füllgrad der Wechseltische (140, 145) nicht überschritten wird.

7. Computerprogrammprodukt mit Programmcodemitteln zur Durchführung des Verfahrens (300) nach einem der vorangehenden Ansprüche, wenn es auf einer Ausführungseinrichtung (115) abläuft oder auf einem computerlesbaren Medium gespeichert ist.

8. Steuereinrichtung (115) für die Bestückung von Leiterplatten (120) mittels einer Festrüstung (165) auf einer Bestückungslinie (110), wobei die Steuereinrichtung (115) dazu eingerichtet ist, ein Verfahren (300) nach einem der Ansprüche 1 bis 6 durchzuführen.

**Claims**

1. Method (300) for populating circuit boards (120) by means of equipment (165, 170) on a populating line (110),

   - wherein the equipment (165, 170) comprises a number of component types (160), which is sufficient to populate a setup family (210, 215) of circuit board types (122), which is assigned to the equipment (165, 170),
   - wherein the equipment (165, 170) is implementable by a number of shuttle tables (140), which are attached to the populating line (110) and which comprise supplies of components (155) of the component types (160),
   - wherein different equipment (165, 170) is attached to the populating line (110) during a planning horizon (205),
   - wherein fixed equipment (165) which is permanently equipped on shuttle tables (140, 145) remains unchanged during the planning horizon (205) and can be used multiple times on the populating line (110);
   - and variant equipment is only temporarily equipped on shuttle tables (140) during the planning horizon and is stripped again after the production of circuit boards, and wherein the method comprises the following steps:
   - acquiring (305) a number of circuit board types (122) with assigned circuit boards (120), which are to be populated on the populating line (110) within the planning horizon (205);
   - assigning (315) circuit board types (122) to a fixed equipment setup family (210),
   - wherein all components (155) for populating a circuit board (120) of a circuit board type (122) of the fixed equipment setup family (210) are comprised by the fixed equipment (165);
   - wherein the assigning (315) is performed such that a space consumption on tracks of the component types (160) assigned to a fixed equipment setup family (210) is less than or equal to the number of tracks which have space in the fixed equipment (165);
   - wherein the circuit board types (122) are assigned items of information regarding the number of component types (160) which are to be populated thereon and regarding a number of populating positions (235) of each circuit board (120);
   - optimizing (375) the assignment by means of mixed integer programming until an assignment quality exceeds a predetermined amount;
   - wherein the assignment quality is determined (340) on the basis of one of the following possibilities:

     a) a number of orders (220) during the planning interval (205), wherein each order (220) relates to populating a number of circuit boards (120) of a predetermined circuit board type (122) of the fixed equipment setup family (210) ;
     b) the total of the circuit boards (120) to be populated within the planning horizon (205) of those circuit board types (122) which are assigned to the fixed equipment setup family (210);
     c) the total of the production times of the circuit boards (120) to be populated within the planning horizon (205) of those circuit board types (122), which are assigned to the fixed equipment setup family (210); and
     d) the total of the populating positions (235) of the circuit boards (122) of the circuit board types (122) which are assigned to the fixed equipment setup family (210),

   - and
   - populating the circuit boards (120) on the populating line (110) by means of the fixed equipment (165).

2. Method (300) according to Claim 1, wherein a plurality of fixed equipment setup families (210) is predefined.

3. Method (300) according to either of the preceding claims, wherein the predetermined amount comprises a proportion of a difference between the assignment quality and a maximum achievable assignment quality (355).

4. Method (300) according to any one of the preceding claims, wherein the optimization (375) is also aborted (370) if no assignment could be found during a predetermined processing time, the assignment quality of which exceeds the predetermined amount.

5. Method (300) according to any one of the preceding claims, wherein the components (155) of the circuit board types (160) of each setup family (210) are assigned to a number of shuttle tables (140, 145) for providing components (155) at the populating line (110) and the assignment of the circuit board types (122) to the setup families (210) is performed (320) under the boundary condition that at least one of the components (155) can only be assigned to a predetermined set of shuttle tables (140, 145).

6. Method (300) according to any one of the preceding claims, wherein the components (155) of the circuit board types (122) of each setup family (210) are assigned to a number of shuttle tables (140, 145) for providing components (155) on the populating line (110) and the assignment of the circuit board types (122) to the setup families is performed (325) under the boundary condition that a maximum degree of filling of the shuttle tables (140, 145) is not exceeded.

7. Computer program product having program code means for carrying out the method (300) according to any one of the preceding claims, when it runs on an execution unit (115) or is stored on a computer-readable medium.

8. Control unit (115) for populating circuit boards (120) by means of fixed equipment (165) on a populating line (110), wherein the control unit (115) is configured to carry out a method (300) according to any one of Claims 1 to 6.

**Revendications**

1. Procédé (300) d'équipement de plaques de circuits imprimés (120) au moyen d'un montage (165, 170) sur une ligne d'équipement (110),

- le montage (165, 170) comprenant un nombre de types de composants (160) suffisant à l'équipement d'une famille de montage (210, 215) associée au montage de types de plaques de circuit imprimé (122),
- le montage (165, 170) étant réalisable par un nombre de tables de transfert (140) placées sur la ligne d'équipement (110) et comprenant les stocks de composants (155) des types de composant (160),
- pendant une période de planification (205) différents montages (165, 170) sont effectués sur la ligne d'équipement (110),
- un montage fixe (165), monté fixe sur des tables de transfert (140, 145), pendant la période de planification (205) restant inchangé et pouvant être plusieurs fois mis en oeuvre sur la ligne d'équipement (110);
- et une variante de montage ne pouvant être montée pendant la période de planification que temporairement sur des tables de transfert (140) et étant à nouveau démontée après la production de plaques de circuit imprimé, et le procédé comprenant les étapes suivantes:
- détection (305) d'un nombre de types de plaques de circuit imprimé (122) avec plaques de circuit imprimé (120) associées devant être équipées sur la ligne d'équipement (110) dans le respect de la période de planification (205);
- association (315) de types de plaques de circuit imprimé (122) sur une famille de montage de montage fixe (210),
- tous les composants (155) pour le montage d'une carte de circuit imprimé (120) d'un type de carte de circuit imprimé (122) de la famille de montage de montage fixe (210) étant compris par le montage fixe (165);
- l'association (315) s'effectuant de sorte qu'une occupation de place sur des pistes de types de composants (160) associés à la famille de montage de montage fixe (210) étant plus petite ou égale au nombre de pistes ayant place dans le montage fixe (165);
- des informations relatives au nombre des types de composants (160) à équiper sur eux étant associées aux types de plaques de circuit imprimé (122) et relatives au nombre de positions d'équipement (235) de chaque plaquette de circuit imprimé (120);
- optimisation (375) de l'association au moyen d'une programmation en nombres entiers mixte, jusqu'à ce qu'une qualité d'association dépasse positivement une mesure prédéterminée;
- la qualité d'association étant déterminée (340) sur base d'une des possibilités suivantes:

a) d'un nombre d'entrées (220) pendant l'intervalle de planification (205), chaque entrée (220) concernant l'équipement d'un nombre de plaques de circuit imprimé (120) d'un type de plaquette de circuit imprimé (122) prédéterminé de la famille de montage de montage fixe (210);
b) de la somme des plaques de circuit imprimé (120) à équiper pendant la période de planification (205), de chaque type de plaques de circuit imprimé (122), qui sont associées à la famille de montage de montage fixe (210);
c) de la somme des périodes de production des plaques de circuit imprimé (120) à équiper pendant la période de planification (205), de chaque type de plaques de circuit imprimé (122), qui sont associées à la famille de montage de montage fixe (210); et
d) de la somme des positions d'équipement (235) des plaques de circuit imprimé (122) des types de plaques de circuit imprimé (122) qui sont associés à la famille de montage de montage fixe (210),

et
- équipement des plaques de circuit imprimé (120) sur la ligne d'équipement (110) au moyen du montage fixe (165).

**2.** Procédé (300) selon la revendication 1, une pluralité de familles de montage de montage fixe (210) étant prédéfinie.

**3.** Procédé (300) selon l'une des revendications précédentes, la mesure prédéterminée comprenant une part d'une différence entre la qualité d'association et une qualité d'association maximale réalisable (355).

**4.** Procédé (300) selon l'une des revendications précédentes, l'optimisation (375) étant interrompue (370) quand, pendant une durée de traitement prédéterminée, aucune association ne peut être trouvée, dont la qualité d'association dépasse positivement la mesure prédéterminée.

**5.** Procédé (300) selon l'une des revendications précédentes, les composants (155) des types de plaques de circuit imprimé (160) étant associés à chaque famille de montage (210) d'un nombre de tables de transfert (140, 145) pour la fourniture de composants (155) sur la ligne d'équipement (110), et l'association des types de plaques de circuit imprimé (122) sur les familles de montage (210) s'effectuant à la condition marginale qu'au moins un des composants (155) ne puisse être associé qu'à une quantité prédéterminée de tables de transfert (140, 145).

**6.** Procédé (300) selon l'une des revendications précédentes, les composants (155) des types de plaques de circuit imprimé (122) de chaque famille de montage (210) étant associés à un nombre de tables de transfert (140, 145) pour la fourniture de composants (155) sur la ligne d'équipement (110), et l'association des types de plaquette de circuit imprimé (122) sur les familles de montage (210) s'effectuant à la condition marginale (325) qu'une densité maximale des tables de transfert (140, 145) ne soit pas dépassée positivement.

**7.** Produit de programme informatique avec moyens de code de programme pour l'exécution du procédé (300) selon l'une des revendications précédentes, quand il tourne sur un dispositif d'exécution (115) ou qu'il est mémorisé sur un support pouvant être lu par un ordinateur.

**8.** Appareil de commande (115) pour l'équipement de plaques de circuit imprimé (120) au moyen d'un montage fixe (165) sur une ligne d'équipement (110), l'appareil de commande (115) étant installé pour exécuter un procédé (300) selon l'une des revendications 1 à 6.

# FIG 1

# FIG 2

200

215   215   215

210

205

225
230
235
240

220   122

220

220

# FIG 3

300

305

310

315

320

325

330

335

340

345  350  355  360

365

375

385

380  370

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19834620 A1
- WO 2010105876 A1